# FASCICULE DE BREVET EUROPEEN

(11) **EP 2 628 245 B1**
(45) Date de publication et mention de la délivrance du brevet: **07.11.2018**
(21) Numéro de dépôt: 11769851.4
(22) Date de dépôt: 10.10.2011
(51) Int. Cl.: H03H 9/56, H03H 9/02

(54) **FILTRE BAW A COUPLAGE LATERAL UTILISANT DES CRISTAUX PHONONIQUES**
LATERAL GEKOPPELTES BAW-FILTER MIT PHONONISCHEN KRISTALLEN
LATERALLY COUPLED BAW FILTER EMPLOYING PHONONIC CRYSTALS

(30) Priorité: 15.10.2010 FR 1058403
(43) Date de publication de la demande: 21.08.2013
(73) Titulaire: Commissariat à l'Énergie Atomique et aux Énergies Alternatives, 75015 Paris (FR)
(72) Inventeur: GORISSE, Marie, F-79180 Chauray (FR); REINHARDT, Alexandre, F-38400 Saint Martin D'heres (FR)
(74) Mandataire: Esselin, Sophie
(86) Numéro de dépôt international: PCT/EP2011/067654
(87) Numéro de publication internationale: WO 2012/049126

(56) Documents cités:
- US-A- 3 573 672
- US-A- 5 495 135
- US-A1- 2005 140 465
- US-B1- 6 492 759
- NAKAMURA K ET AL: "THIN FILM RESONATORS AND FILTERS", INTERNATIONAL SYMPOSIUM ON ACOUSTIC WAVE DEVICES FOR FUTUREMOBILE COMMUNICATION SYSTEMS, 5 mars 2001 (2001-03-05), pages 93-99, XP008048920,
- OLSSON III R H ET AL: "TOPICAL REVIEW; Microfabricated phononic crystal devices and applications", MEASUREMENT SCIENCE AND TECHNOLOGY, IOP, vol. 20, no. 1, janvier 2009 (2009-01), page 12002, XP020152528,

## Description

Le domaine de l'invention est celui des dispositifs électromécaniques exploitant la propagation d'ondes acoustiques dans des couches piézoélectriques en vue de réaliser des fonctions de filtre électrique.

De tels dispositifs présentent des fréquences de fonctionnement de l'ordre de quelques centaines de MHz à quelques GHz, et sont utilisés dans des circuits de transmission radiofréquence (téléphone portable, liaison radio, échange de données sans fil,...), de traitement du signal ou dans des systèmes de capteurs.

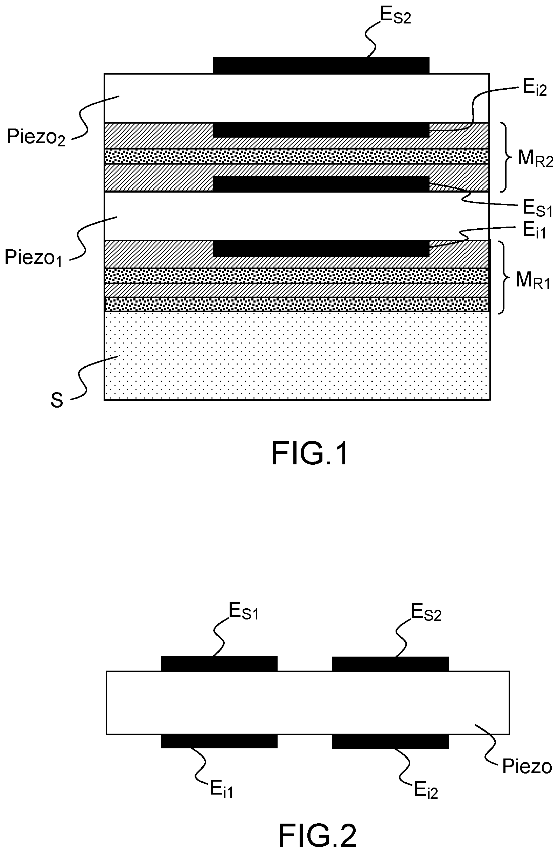

La plupart des filtres acoustiques actuellement réalisés à partir de résonateurs BAW (Bulk Acoustic Wave) sont couplés électriquement. Certaines fonctions nécessitant l'isolation électrique entre l'entrée et la sortie du filtre sont cependant encore délicates : elles nécessitent un balun, un montage couteux en encombrement et en pertes électriques. Il est possible de se passer de cet inconvénient en utilisant un couplage acoustique. Dans cette optique, les CRF acronyme de « Coupled Resonator Filters » tels que ceux illustrés en figure 1 ont été développés, comme décrit dans les articles suivants : G.G. Fattinger, J. Kaitila, R. Aigner and W. Nessler, Single-to-balanced Filters for Mobile Phones using Coupled Resonator BAW Technology, 2004 IEEE Ultrasonics Symposium, pp. 416-419, J.D. Larson, R.C. Ruby, *Thin-film acoustically-coupled transformer,* brevet US 6946928 B2, Sept. 2005. Plus précisément, un substrat S comporte un empilement de couches dans lequel sont définis :
- une structure de miroir de Bragg MR₁ ;
- une couche de premier matériau piézoélectrique P_{iézo1} inséré entre une première électrode inférieure Eᵢ₁ et une première électrode supérieure Eₛ₁ ;
- une seconde structure de miroir de Bragg MR₂ ;
- une couche de second matériau piézoélectrique P_{iézo2} inséré entre une seconde électrode inférieure Eᵢ₂ et une seconde électrode supérieure Eₛ₂.

Ces structures permettent de répondre à ce besoin en limitant la surface nécessaire et les pertes, mais nécessitent un procédé technologique très lourd pour leur réalisation tels que décrit dans l'article : C. Billard, N. Buffet, A. Reinhardt, G. Parat, S. Joblot and P. Bar, 200mm Manufacturing Solution for Coupled Resonator Filters, Proceedings of the 39th European Solid-State Device Research Conférence (ESSDERC 2009), pp. 133-136.

Dans le domaine des filtres acoustiques et notamment sur matériau piézoélectrique de quartz, dits monolithiques, il a déjà été proposé d'utiliser un couplage latéral entre résonateurs comme illustré en figure 2, les résonateurs étant placés côte à côte. Le matériau piézoélectrique P_{iézo} est inséré entre deux électrodes supérieures et inférieures respectivement Eₛ₁, Eᵢ₁ et Eₛ₂, Eᵢ₂. On excite alors des ondes de cisaillement d'épaisseur TS correspondant à l'acronyme de « Thickness Shear » qui sont naturellement évanescentes en-dehors des résonateurs, et en faisant varier la distance entre les résonateurs, on peut faire varier l'énergie transmise et ainsi modifier la largeur de la bande passante du filtre. Le filtre est alors appelé filtre à couplage latéral ou filtre monolithique. Cela fonctionne bien pour des filtres réalisés sur substrat piézoélectrique (notamment le quartz), mais ces résonateurs ont une fréquence de résonance faible (pas plus de quelques centaines de MégaHertz) due à leur forte épaisseur et ils ne sont pas compatibles avec des technologies CMOS (pour la téléphonie mobile, par exemple).

Lorsqu'on transfère ces filtres sur des couches minces, d'épaisseur de l'ordre du micromètre, comme décrit dans l'article J. Meltaus, T. Pensala, K. Kokkonen and A. Jansman, Laterally coupled solidly mounted BAW resonators at 1.9 GHz, 2009 Ultrasonics Symposium Proceedings, on utilise des matériaux piézoélectriques compatibles CMOS, comme par exemple le nitrure d'aluminium (AIN) ou l'oxyde de zinc (ZnO). Naturellement cependant, ces matériaux présentent des caractéristiques acoustiques faisant que les ondes s'y propageant ne sont pas *a priori* évanescentes en dehors des résonateurs. Une structure comme celle de la figure 2, conduit donc à des résonateurs très fortement couplés, quelle que soit la distance entre eux, ce qui se traduit par un comportement global identique à celui d'un simple résonateur.

Par adjonction d'autres matériaux à l'empilement, ou en utilisant l'effet de perturbation apporté par un miroir de Bragg, on peut toutefois modifier le comportement acoustique de l'empilement et se ramener à des conditions de propagation similaires à celles existant naturellement dans le quartz comme décrit dans G.G. Fattinger, S. Marksteiner, J. Kaitila and R. Aigner, Optimization of acoustic dispersion for high performance thin film BAW resonators, 2005 IEEE Ultrasonics Symposium Proceedings, pp. 1175-1178.

C'est la solution qui a par exemple été décrite dans l'article J. Meltaus, T. Pensala, K. Kokkonen and A. Jansman, Laterally coupled solidly mounted BAW resonators at 1.9 GHz, 2009 Ultrasonics Symposium Proceedings.

Dans ce cas, la distance entre deux résonateurs couplés latéralement, correspondant à la longueur d'évanescence, est très faible, typiquement de l'ordre de grandeur de l'épaisseur de la couche. Il est alors délicat de gérer précisément la distance entre les résonateurs, et donc le couplage, ce qui influe directement sur la largeur de la bande passante du filtre.

Dans ce contexte la présente invention a pour objet une solution de filtre à couplage latéral en utilisant un matériau piézoélectrique qui ne satisfait pas forcément naturellement les conditions d'évanescence des ondes en introduisant des cristaux phononiques permettant de diminuer le coefficient de transmission des ondes élastiques se propageant latéralement. Il est rappelé qu'un cristal phononique est une organisation périodique de plusieurs matériaux acoustiquement différents, ce qui provoque une modification des conditions de propagation des ondes acoustiques. Pour certaines organisations de matériaux on peut voir apparaitre des bandes d'arrêt : des plages de fréquences pour lesquelles aucune onde acoustique ne se propage. Concrètement, ceci signifie qu'une onde pénétrant dans ce cristal se voit atténuée au fur et à mesure de sa pénétration dans cette structure, c'est ce phénomène qu'il est proposé d'utiliser dans la présente invention afin de moduler la propagation des ondes acoustiques latérales au sein de filtres à ondes acoustiques de volume.

Plus précisément, la présente invention a pour objet un filtre passe bande à ondes acoustiques comprenant aux moins deux résonateurs à ondes acoustiques de volume, couplés entre eux acoustiquement latéralement, chaque résonateur comportant une couche de matériau piézoélectrique et au moins une première électrode et/ou une seconde électrode , lesdites ondes de volume se propageant dans une direction perpendiculaire au plan de la couche du matériau piézoélectrique, caractérisé en ce que :
- il comprend en outre au moins une première structure de cristal phononique entre lesdits résonateurs, disposée de manière à pouvoir diminuer le coefficient de transmission des ondes acoustiques latérales selon une direction parallèle au plan de la couche piézoélectrique ;
- la première structure de cristal phononique est réalisée dans une matrice de matériau diélectrique ou avec des motifs en matériau diélectrique.

Ainsi et avantageusement, des éléments isolants électriques sont utilisés plutôt que des éléments métalliques tels que des cristaux phononiques réalisés à partir de motifs métalliques pour former des réseaux d'éléments conducteurs électriquement localisés entre l'entrée et la sortie du filtre ce qui a pour effet de court-circuiter l'entrée et la sortie du filtre et ainsi réduire son effet d'injection de fréquences non désirées.

Selon une variante de l'invention, la structure de cristal phononique est située dans la couche de matériau piézoélectrique.

Selon une variante de l'invention, les résonateurs étant formés à partir d'un empilement de couches, la structure de cristal phononique comporte des motifs en surface de l'empilement et/ou sous ledit empilement et/ou dans au moins une couche dudit empilement.

Selon une variante de l'invention, les motifs de la structure phononique sont en SiO₂, ou en SiN ou en Mo ou en W ou en AlN.

Selon une variante de l'invention, la structure de cristal phononique est unidimensionnelle.

Selon une variante de l'invention, la structure de cristal phononique est bidimensionnelle.

Selon une variante de l'invention, la structure de cristal phononique est tridimensionnelle.

Selon une variante de l'invention, le matériau piézoélectrique étant en AlN.

Selon une variante de l'invention, le matériau piézoélectrique étant en LiNbO₃.

Selon une variante de l'invention, la structure de cristal phononique comporte des inclusions et/ou des espèces diffusées.

Ces inclusions sont obtenues notamment par implantation atomique ou par diffusion d'espèces chimiques.

Selon une variante de l'invention, les inclusions sont obtenues par implantation d'atomes d'hydrogène.

Selon une variante de l'invention, la structure de cristal phononique comporte des trous.

Selon une variante de l'invention, le filtre comprend en outre des secondes structures de cristal phononique à la périphérie desdits résonateurs, présentant des coefficients d'atténuation des ondes acoustiques dites latérales supérieures aux coefficients d'atténuation des premières structures de cristal phononique situées entre les deuxdits résonateurs.

Selon une variante de l'invention, les résonateurs comprennent une électrode supérieure et une électrode inférieure.

Selon une variante de l'invention, les résonateurs comprennent un couple d'électrodes positionnées à la surface du matériau piézoélectrique.

Selon une variante de l'invention, le filtre comporte en outre une structure acoustique permettant d'isoler acoustiquement le filtre, cette structure étant un miroir de Bragg, et/ou une cavité et/ou une troisième structure de cristal phononique.

Plus généralement, pour former un cristal phononique, l'invention peut utiliser tout procédé faisant :
- soit intervenir une implantation d'atomes dans un matériau piézoélectrique, de manière à former soit un nouveau matériau (nouvelle phase), soit ledit matériau avec des inclusions de dimensions inférieures à la longueur d'onde de propagation dans le dit matériau ;
- soit intervenir un procédé entraînant la diffusion d'espèces chimiques dans le matériau entrainant également la formation d'un nouveau matériau.

De même, le miroir de Bragg peut être réalisé par implantation d'atomes dans le matériau piézoélectrique, pour former soit un nouveau matériau soit ledit matériau avec des inclusions de dimensions inférieures à la longueur d'onde de propagation dans le dit matériau.

L'invention sera mieux comprise et d'autres avantages apparaîtront à la lecture de la description qui va suivre donnée à titre non limitatif et grâce aux figures annexées parmi lesquelles :
- la figure 1 illustre une structure de filtre selon l'art connu comprenant des résonateurs couplés à ondes de volume utilisant des structures de miroir de Bragg ;
- la figure 2 illustre deux résonateurs utilisant un couplage latéral dans un matériau tel que le quartz selon l'art connu ;
- la figure 3 illustre une variante de filtre selon l'invention utilisant un cristal phononique de manière à optimiser les ondes latérales entre les résonateurs à ondes de volume ;
- la figure 4 illustre une variante de filtre de type SMR selon l'invention utilisant un cristal phononique de manière à optimiser les ondes latérales entre les résonateurs à ondes de volume ;
- la figure 5 illustre une variante de filtre FBAR selon l'invention utilisant un cristal phononique de manière à optimiser les ondes latérales entre les résonateurs à ondes de volume ;
- les figure 6a et 6b illustrent respectivement une vue en coupe et une vue de dessus d'une variante de filtre selon l'invention comportant en outre des régions périphériques comportant des cristaux phononiques pour diminuer les ondes latérales en périphérie ;
- la figure 7 illustre les performances électriques d'un filtre selon l'invention ;
- les figures 8a à 8e illustrent les étapes d'un procédé de fabrication d'un exemple de filtre à résonateurs de type FBAR selon l'invention ;
- la figure 9 illustre une vue de dessus de l'exemple de filtre à résonateurs de type FBAR réalisé selon les étapes illustrées en figures 8a à 8e ;
- les figures 10a à 10d illustrent les étapes d'un procédé de fabrication d'un filtre à résonateurs de type SMR selon l'invention ;
- la figure 11 illustre une vue de dessus de l'exemple de filtre à résonateurs de type SMR réalisé selon les étapes illustrées en figures 10a à 10d ;
- les figures 12a à 12f illustrent les étapes de procédé de fabrication d'un exemple de filtre d'un filtre selon l'invention comprenant des résonateurs de type SMR et un cristal phononique 2D réalisés dans la couche de matériau piézoélectrique ;
- les figures 13a à 13c illustrent les étapes de procédé de fabrication d'un exemple de filtre à résonateurs SMR comportant une structure de miroir de Bragg implantée et des structures de cristal phononique 3D au sein d'un substrat de matériau piézoélectrique.

Selon la présente invention, le filtre comporte un empilement BAW présentant une propagation des ondes acoustiques latérales. On force l'évanescence des ondes latérales en insérant au moins un cristal phononique dans l'espace entre deux résonateurs. L'évanescence des modes se propageant latéralement est déterminée selon des calculs tels que ceux décrits par exemple dans l'article de V. Laude, B. Aoubiza, Y. Achaoui, S. Benchabane and A. Khélif, Band structure of evanescent waves in phononic crystals, 2008 IEEE Ultrasonics Symposium Proceedings, pp. 249-252. La connaissance de l'évanescence des ondes latérales permet de déterminer le nombre de périodes du cristal phononique nécessaires pour obtenir un filtre à couplage latéral possédant des caractéristiques (bande passante notamment) voulues.

On peut indifféremment utiliser ici un cristal phononique 1D, 2D ou 3D, pourvu qu'il limite la propagation des ondes latérales. Le cristal phononique doit être composé d'au moins deux matériaux acoustiquement différents qui peuvent être l'air, le matériau piézoélectrique utilisé pour la couche, ou tout autre solide ou fluide.

L'adjonction d'un cristal phononique entre les résonateurs peut se faire pour des résonateurs BAW sur miroir de Bragg ou sur membrane, voire pour des HBAR, acronyme de « High overtone Bulk Acoustic Resonator ».

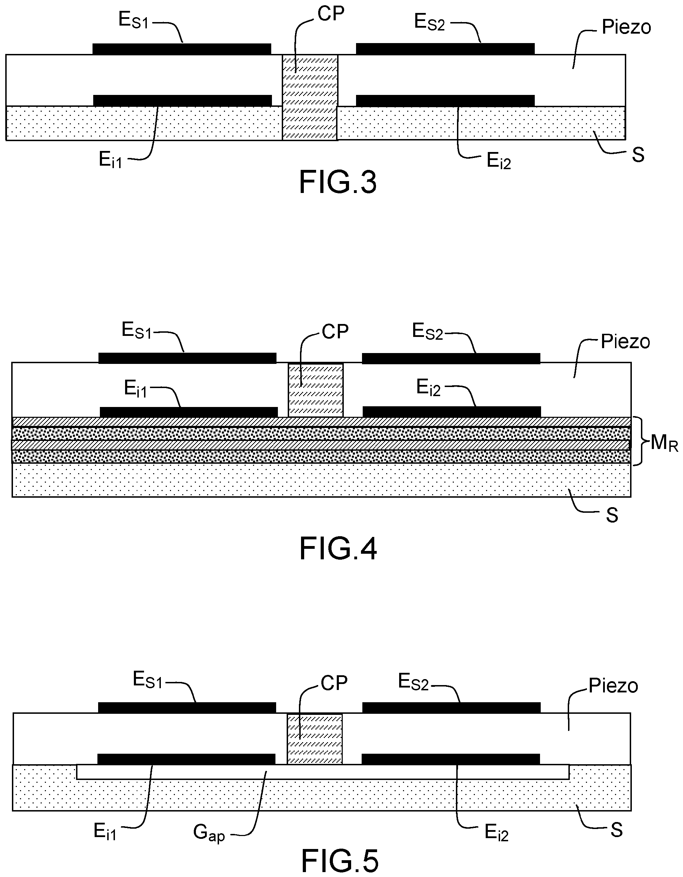

Les figures 3, 4 et 5 illustrent à cet égard, respectivement des configurations de filtres à résonateurs de type SMR (pour *Solidly Mounted Resonator),* avec structure de miroir de Bragg et de filtres à résonateurs de type FBAR (Film Bulk Acoustique Resonator) comportant une région centrale comportant un cristal phononique CP, entre les deux résonateurs à ondes de volume définis respectivement avec les paires d'électrodes Eₛ₁, Eᵢ₁ et Eₛ₂, Eᵢ₂ et le matériau piézoélectrique P_{iézo} , défini à la surface d'un substrat S, dans le cas du filtre à résonateurs FBAR, un gap Gₐₚ sépare la membrane définie dans le matériau piézoélectrique du substrat.

### Exemple de réalisation d'un filtre selon l'invention comprenant un cristal phononique unidimensionnel réalisé en surface :

Le filtre comprend une couche de matériau piézoélectrique d'AIN d'une épaisseur pouvant être typiquement de l'ordre de 1 µm et constitutive d'une membrane séparée du substrat (non représenté) par un gap d'air.

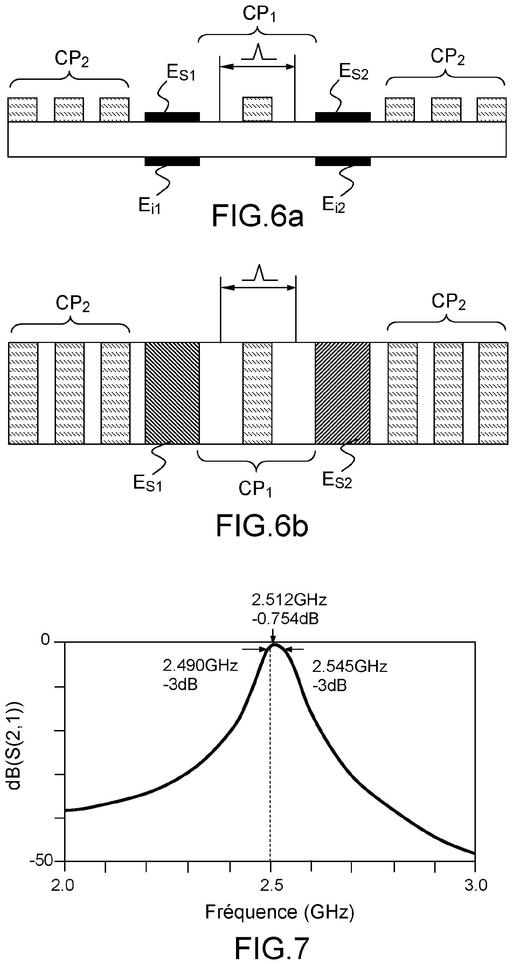

Selon cet exemple, la structure de cristal phononique centrale CP₁ est définie par une ligne centrale réalisée à la surface du matériau piézoélectrique, centrée entre les jeux d'électrodes Eₛ₁, Eᵢ₁ et Eₛ₂, Eᵢ₂ des deux résonateurs couplés et définissant ainsi une période Λ de ladite structure de cristal phononique, comme représenté en figure 6a.

Les résonateurs sont réalisés avec des électrodes en molybdène d'une épaisseur pouvant typiquement être de l'ordre de 200 nm, pour une surface de 50x300 µm². Le filtre comprend une série de lignes de dioxyde de silicium SiO₂ déposées sur la couche d'AlN, d'une épaisseur de 500 nm, d'une largeur de 15 µm. On place une ligne de SiO₂ entre les résonateurs de manière à constituer un premier cristal phononique CP₁ et on isole le filtre en périphérie par 3 lignes de chaque côté, constitutives de seconds cristaux phononiques CP₂, comme illustré en figures 6a et 6b.

La figure 7 présente la transmission en dB en fonction de la fréquence obtenue avec le filtre décrit ci-dessus. On obtient une bande passante à -3 dB de 55 MHz centrée sur 2,51 GHz.

### Exemple de réalisation d'un filtre selon l'invention comprenant des résonateurs de type FBAR (tels que ceux décrits par exemple par N.K. Kuo, C.J. Zuo, G. Piazza, Démonstration of Inverse Acoustic Band Gap Structures in AIN and Intégration with Piezoelectric Contour Mode Wideband Transducers, 2009 IEEE Solid-State- Sensors, Actuators and Microsystems symposium, pp1 0-13, 2009) et un cristal phononique réalisé par gravure de la couche de matériau piézoélectrique

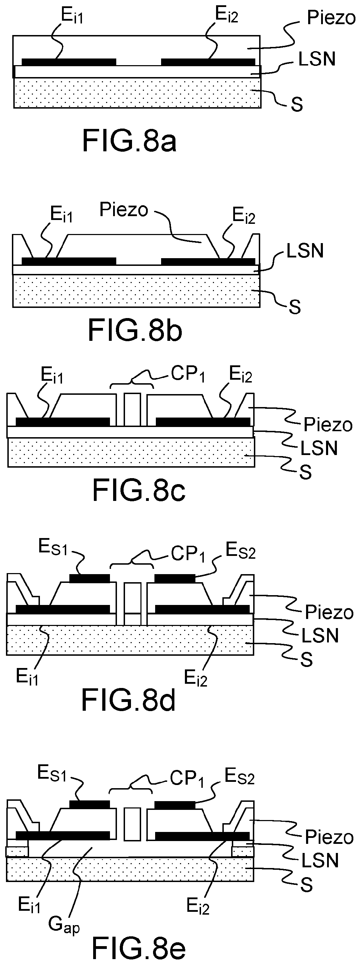

Les figures 8a à 8e illustrent les différentes étapes d'un exemple de procédé de fabrication d'un filtre à résonateurs de type FBAR tel que celui illustré en figure 5 et dans lequel, le cristal phononique est défini par gravure de la couche de matériau piézoélectrique.

La figure 8a illustre la première étape du procédé, à partir d'un substrat de silicium S d'épaisseur typiquement d'environ 700 µm, on procède au dépôt d'une couche dite «LSN » de l'acronyme de Low Stress Nitride d'épaisseur environ 300 nm. Puis on procède au dépôt d'une couche de platine Pt d'épaisseur 200 nm et à une étape de lithographie de ladite couche par lift-off de manière à définir les deux électrodes inférieures Eᵢ₁ et Eᵢ₂ et enfin on procède au dépôt d'une couche de matériau piézoélectrique P_{iezo} en nitrure d'aluminium AlN d'épaisseur environ 2 µm.

La figure 8b illustre une étape de gravure humide au KOH de l'AlN pour les accès aux électrodes inférieures Eᵢ₁ et Eᵢ₂.

La figure 8c illustre une étape de gravure sèche de l'AlN pour définir le cristal phononique CP₁.

La figure 8d illustre le dépôt d'une couche de Platine destinée à la réalisation des électrodes supérieures Eₛ₁, Eₛ₂ d'épaisseur environ 200 nm par lithographie de la couche de platine et par procédé lift-off.

La figure 8e illustre la libération au difluorure de xénon XeF₂ de la membrane, isolée du substrat par un gap d'air Gₐₚ.

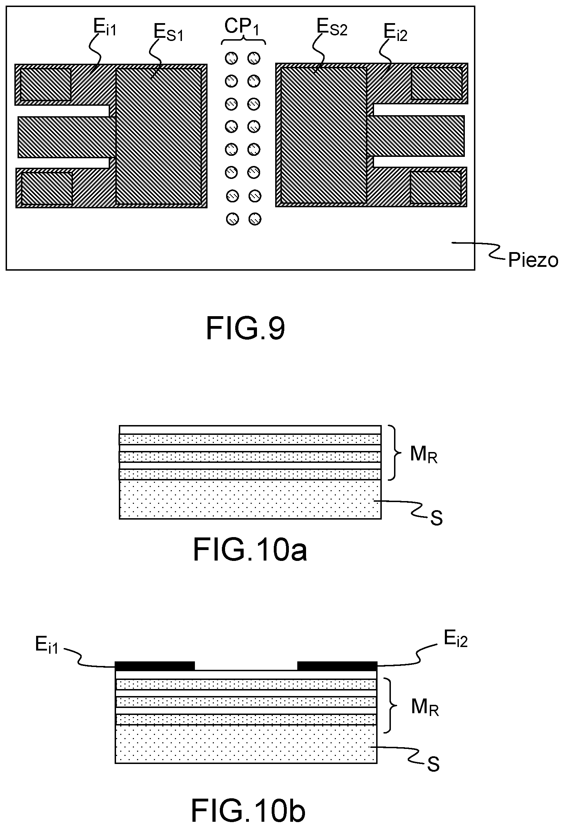

La figure 9 illustre une vue de dessus de l'exemple de filtre dont les étapes de procédé sont illustrées en figure 8a à 8e.

### Exemple de réalisation d'un filtre selon l'invention comprenant des résonateurs de type SMR et un cristal phononique réalisé à la surface de la couche de matériau piézoélectrique.

Les figures 10a à 10d illustrent les différentes étapes d'un exemple de procédé de fabrication d'un filtre à résonateurs de type SMR séparés par un cristal phononique constitué de lignes de silice disposées dans l'espace entre les résonateurs, au-dessus de la couche de matériau piézoélectrique.

Il est à noter qu'il peut tout aussi bien être envisagé de réaliser la structure de cristal phononique en-dessous et/ou avantageusement au-dessus et en-dessous de la couche piézoélectrique.

Comme illustré sur la figure 10a, à partir d'un substrat de silicium S, on procède à une opération d'oxydation thermique dudit substrat en SiO₂ sur une épaisseur de 1µm, puis on procède à des dépôts successifs de :
- nitrure de silicium SiN sur une épaisseur de l'ordre de 0.8 µm ;
- oxycarbure de silicium SiOC sur une épaisseur d'environ 1 µm ;
- SiN sur une épaisseur d'environ 0.5 µm ;
- SiOC sur une épaisseur d'environ 1 µm ;
- SiN sur une épaisseur d'environ 0.5 µm et
- SiO₂ sur une épaisseur d'environ 0.6 µm de manière à définir une structure de miroir de Bragg MR.

La figure 10b illustre la formation des deux électrodes inférieures Eᵢ₁ et Eᵢ₂ par le dépôt d'une couche de molybdène Mo sur une épaisseur de 0.3 µm puis par lithographie, gravure et retrait du masque de gravure.

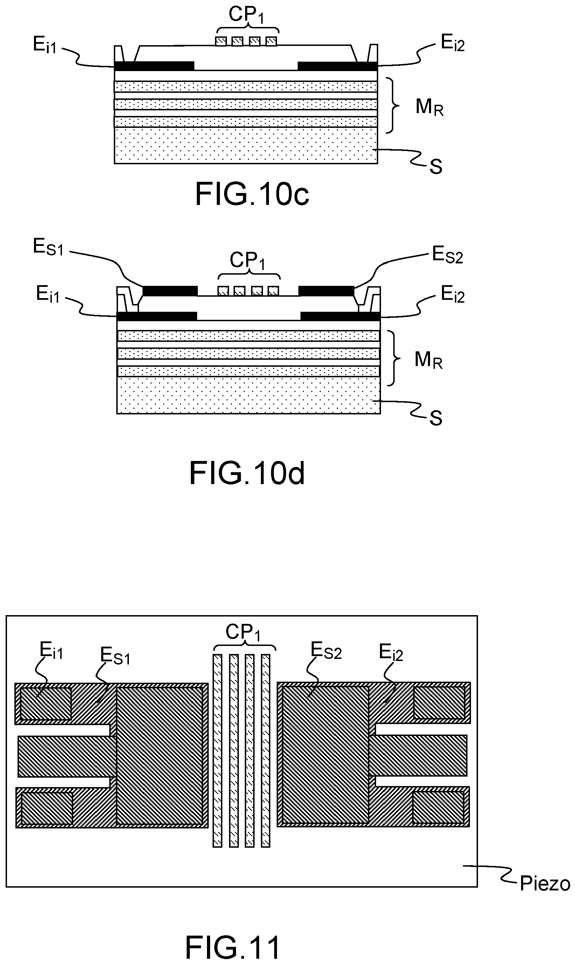

La figure 10c illustre la formation du cristal phononique grâce aux opérations successives suivantes :
- le dépôt de la couche de matériau piézoélectrique en AIN sur une épaisseur de 1,7 µm ;
- le dépôt d'une couche en SiO₂ d'épaisseur de l'ordre de 0,5 µm permettant la réalisation de cristal phononique CP₁, suivie d'une étape de lithographie, de gravure et du retrait local de la couche de SiO₂ ;
- la gravure et le retrait local de la couche d'AIN pour ouvrir les reprises de contact.

La figure 10d illustre la réalisation des électrodes supérieures Eₛ₁ et Eₛ₂ par le dépôt d'une couche de molybdène Mo sur une épaisseur de 0.3 µm puis par lithographie, gravure et retrait du masque de gravure.

Il est ainsi nécessaire d'avoir 4 niveaux de masques. Le cristal phononique pourrait aussi être constitué de lignes de molybdène pour éviter quelques étapes technologiques, mais des couplages électriques entre les lignes métalliques et les résonateurs sont cependant à craindre.

La figure 11 illustre une vue de dessus de l'exemple de filtre dont les étapes de procédé sont illustrées ci-dessus avec les reprises de contact inférieures et supérieures des électrodes.

### Exemple de réalisation d'un filtre selon l'invention comprenant des résonateurs de type SMR et un cristal phononique 2D réalisés dans la couche de matériau piézoélectrique.

Le filtre est composé de résonateurs SMR et de structures de cristal phononique en 2D.

La structure bidimensionnelle formant le cristal phononique est réalisée dans un substrat piézoélectrique de niobate de lithium par un procédé dit d'échange protonique, consistant à former des zones où le niobate de lithium d'origine et chimiquement transformé en acide niobique (HNbO₃) ou en un composé de type LiₓH₁₋ₓNbO₃ comme décrit par exemple dans l'article J.L. Jackel, C.E. Rice et J.J. Veselka, Proton exchange for high-index waveguides in LiNbO3, Applied Physics Letters vol. 41, n°7, p. 607-608 (1982). Ce matériau possédant des propriétés acoustiques sensiblement différentes de celles du niobate de lithium d'origine, la structure bidimensionnelle présente des propriétés de cristal phononique.

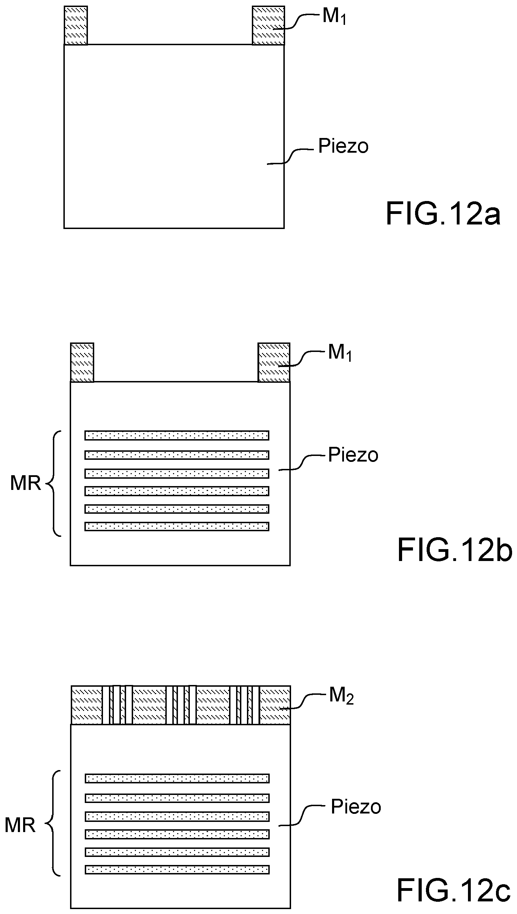

Le miroir de Bragg qui isole la structure du substrat est lui aussi constitué de couches de LiₓH₁₋ₓNbO₃ créées également par une réaction d'échange protonique, mais cette fois par implantation d'hydrogène dans le niobate de lithium, afin de former des inclusions totalement enterrées (et non pas proches de la surface). Les étapes technologiques nécessaires à la réalisation sont les suivantes et sont illustrées à l'aide des figures suivantes :
Comme illustré en figure 12a, on procède au nettoyage d'un substrat piézoélectrique P_{iézo} de Niobate de Lithium puis à une opération de photolithographie pour définir un premier masque M₁ couvrant les zones implantées.

Puis on procède à des opérations d'implantations d'hydrogène successives, par énergie décroissante, afin de former un profil d'implantation périodique, constitutif du miroir de Bragg MR, comme illustré en figure 12b.

On réalise ensuite le retrait du masque de résine par une nouvelle opération de photolithographie pour définir le second masque M₂ à l'échange protonique comme illustré en figure 12c.

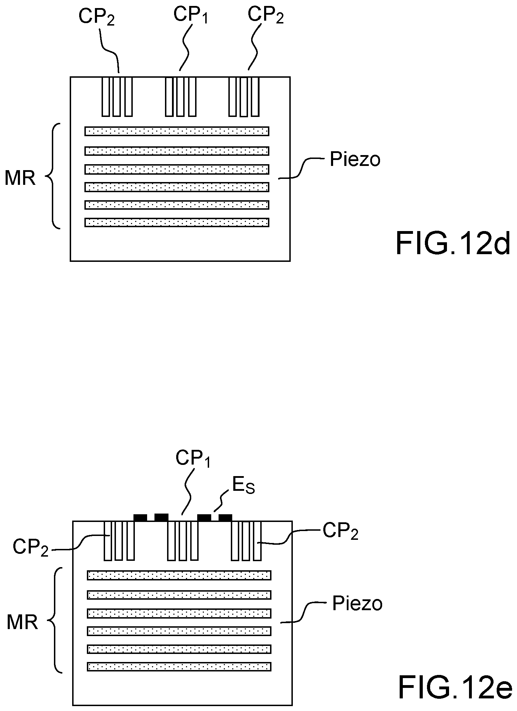

On effectue alors l'échange protonique par immersion dans un bain d'acide benzoïque (C₆H₅COOH) fondu (à une température supérieure à 249°C). Rinçage à l'alcool. Retrait de résine, comme illustré en figure 12d, permettant de définir des structures de cristal phononique CP₁ et CP₂.

On procède enfin aux opérations suivantes : dépôt, photolithographie, gravure et retrait de résine pour définir les électrodes supérieures Es, par exemple en aluminium, comme illustré en figure 12e.

Selon cette variante, chaque résonateur comporte un couple d'électrodes supérieures Eₛ à la surface du matériau piézoélectrique, les électrodes au sein d'un même couple étant très proches, typiquement séparées de moins de quelques microns, les ondes acoustiques étant toujours propagées dans le volume du matériau piézoélectrique mais générées par un champ électrique parallèle au plan dudit matériau.

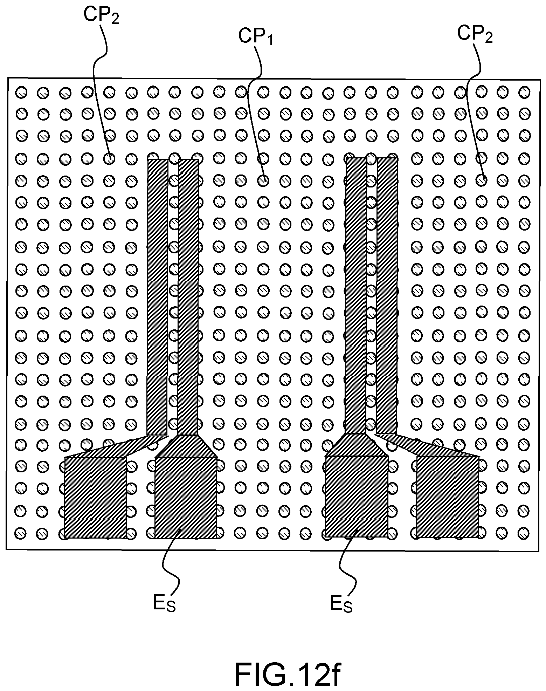

La figure 12f illustre une vue de dessus de l'exemple de filtre dont les étapes de réalisation ont été décrites ci-dessus.

### Exemple de réalisation d'un filtre selon l'invention comprenant des résonateurs de type SMR et un cristal phononique 3D réalisés dans la couche de matériau piézoélectrique.

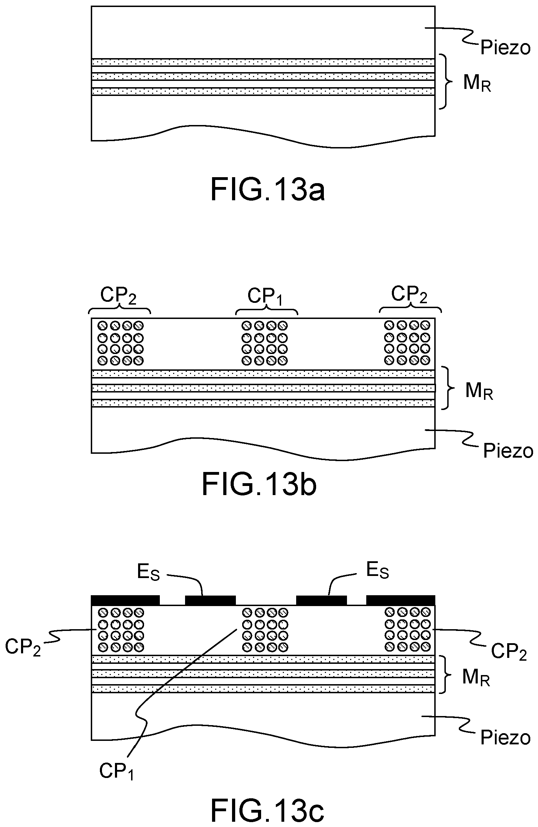

Le filtre est composé de résonateurs SMR et de structures de cristal phononique en 3D, réalisés en implantant localement de l'hydrogène dans un substrat de niobate de lithium LiNbO₃. Les étapes technologiques nécessaires à la réalisation sont les suivantes et sont illustrées à l'aide des figures 13a à 13c.

Selon cette variante chaque résonateur comporte un couple d'électrodes supérieures Eₛ à la surface du matériau piézoélectrique, les électrodes au sein d'un même couple étant très proches, typiquement séparées de moins de quelques microns, les ondes acoustiques étant toujours propagées dans le volume du matériau piézoélectrique mais générées par un champ électrique parallèle au plan dudit matériau.

La figure 13a illustre les opérations successives d'implantation d'hydrogène dans un substrat P_{iezo} de niobate de lithium LiNbO₃ pour former des couches de LiₓH₁₋ₓNbO₃ et ainsi définir une structure de miroir de Bragg MR.

La figure 13b illustre la réalisation des structures de cristaux phononiques CP₁ et CP₂ effectuées par masquage et implantations successives d'hydrogène à des épaisseurs différentes, puis retrait du masque non représenté.

La figure 13c illustre la réalisation des électrodes supérieures Eₛ, ainsi que les reprises de contact, effectuées par dépôt, lithographie, gravure et retrait d'une couche supérieure d'aluminium.

## Revendications

1. Filtre passe bande à ondes acoustiques comprenant aux moins deux résonateurs à ondes acoustiques de volume, couplés entre eux acoustiquement latéralement, chaque résonateur comportant une couche de matériau piézoélectrique (P_{iezo}) et au moins une première électrode (Eₛ₁, Eₛ₂, Eₛ) et/ou une seconde électrode (Eᵢ₁, Eᵢ₂, Eₛ), lesdites ondes de volume se propageant dans une direction perpendiculaire au plan de la couche du matériau piézoélectrique, **caractérisé en ce que** :
- il comprend en outre au moins une première structure de cristal phononique (CP₁) présentant une organisation périodique de plusieurs matériaux acoustiquement différents générant des bandes d'arrêt correspondant à des plages de fréquences pour lesquelles aucune onde acoustique ne se propage entre lesdits résonateurs et disposée de manière à pouvoir diminuer le coefficient de transmission des ondes acoustiques latérales selon une direction parallèle au plan de la couche piézoélectrique ;
- la première structure de cristal phononique est réalisée dans une matrice de matériau diélectrique ou avec des motifs en matériau diélectrique.

2. Filtre passe bande à ondes acoustiques selon la revendication 1, **caractérisé en ce que** la structure de cristal phononique est située dans la couche de matériau piézoélectrique.

3. Filtre passe bande à ondes acoustiques selon la revendication 1, **caractérisé en ce que** les résonateurs étant formés à partir d'un empilement de couches, la structure de cristal phononique comporte des motifs en surface de l'empilement et/ou sous ledit empilement et/ou dans au moins une couche dudit empilement.

4. Filtre passe bande à ondes acoustiques selon la revendication 3, **caractérisé en ce que** les motifs de la structure phononique sont en SiO₂, ou en SiN ou en Mo ou en W ou en AIN.

5. Filtre passe bande à ondes acoustiques selon l'une des revendications 1 à 4, **caractérisé en ce que** la structure de cristal phononique est unidimensionnelle.

6. Filtre passe bande à ondes acoustiques selon l'une des revendications 1 à 4, **caractérisé en ce que** la structure de cristal phononique est bidimensionnelle.

7. Filtre passe bande à ondes acoustiques selon la revendication 1 ou 2, **caractérisé en ce que** la structure de cristal phononique est tridimensionnelle.

8. Filtre passe bande à ondes acoustiques selon l'une des revendications 1 à 7, **caractérisé en ce que** le matériau piézoélectrique étant en AIN.

9. Filtre passe bande à ondes acoustiques selon l'une des revendications 1 à 7, **caractérisé en ce que** le matériau piézoélectrique étant en LiNbO₃.

10. Filtre passe bande à ondes acoustiques selon l'une des revendications 1 à 9, **caractérisé en ce que** la structure de cristal phononique comporte des inclusions et/ou des espèces diffusées.

11. Filtre passe bande à ondes acoustiques selon les revendications 9 et 10, **caractérisé en ce que** les inclusions sont obtenues par implantation d'atomes d'hydrogène.

12. Filtre passe bande à ondes acoustiques selon l'une des revendications 1 à 9, **caractérisé en ce que** la structure de cristal phononique comporte des trous.

13. Filtre passe bande à ondes acoustiques selon l'une des revendications 1 à 12, **caractérisé en ce qu'**il comprend en outre des secondes structures de cristal phononique (CP₂) à la périphérie desdits résonateurs, présentant des coefficients d'atténuation des ondes acoustiques dites latérales supérieures aux coefficients d'atténuation des premières structures de cristal phononique situées entre les deuxdits résonateurs.

14. Filtre passe bande à ondes acoustiques selon l'une des revendications 1 à 13, **caractérisé en ce que** les résonateurs comprennent une électrode supérieure et une électrode inférieure.

15. Filtre passe bande à ondes acoustiques selon l'une des revendications 1 à 13, **caractérisé en ce que** les résonateurs comprennent un couple d'électrodes positionnées à la surface du matériau piézoélectrique.

16. Filtre passe bande à ondes acoustiques selon l'une des revendications 1 à 15, **caractérisé en ce qu'**il comporte en outre une structure acoustique permettant d'isoler acoustiquement le filtre, cette structure étant un miroir de Bragg, et/ou une cavité et/ou une troisième structure de cristal phononique.

## Patentansprüche

1. Bandpassfilter für Schallwellen, das wenigstens zwei Resonatoren mit akustischen Volumenschallwellen umfasst, die miteinander akustisch lateral gekoppelt sind, wobei jeder Resonator eine piezoelektrische Materialschicht (P_{iezo}) und wenigstens eine erste Elektrode (Eₛ₁, Eₛ₂, Eₛ) und/oder eine zweite Elektrode (Eᵢ₁, Eᵢ₂, Eₛ) umfasst, wobei sich die Volumenwellen in einer Richtung lotrecht zur Ebene der Schicht des piezoelektrischen Materials ausbreiten, **dadurch gekennzeichnet, dass**:
- es ferner wenigstens eine erste phononische Kristallstruktur (CP₁) umfasst, die eine periodische Organisation von mehreren akustisch unterschiedlichen Materialien präsentieren, die Stoppbänder entsprechend Frequenzbereichen erzeugen, für die sich keine Schallwelle zwischen den Resonatoren ausbreitet, und so angeordnet, dass sie den Transmissionskoeffizienten der lateralen Schallwellen in einer Richtung parallel zur Ebene der piezoelektrischen Schicht verringern können;
- die erste phononische Kristallstruktur in einer Matrix aus dielektrischem Material oder mit Mustern aus dielektrischem Material realisiert ist.

2. Bandpassfilter für Schallwellen nach Anspruch 1, **dadurch gekennzeichnet, dass** sich die phononische Kristallstruktur in der piezoelektrischen Materialschicht befindet.

3. Bandpassfilter für Schallwellen nach Anspruch 1, **dadurch gekennzeichnet, dass** die phononische Kristallstruktur, da die Resonatoren auf der Basis eines Stapels von Schichten gebildet sind, Muster an der Oberfläche des Stapels und/oder unter dem Stapel und/oder in wenigstens einer Schicht des Stapels umfasst.

4. Bandpassfilter für Schallwellen nach Anspruch 3, **dadurch gekennzeichnet, dass** die Muster der phononischen Struktur aus SiO₂ oder aus SiN oder aus Mo oder aus W oder aus AIN sind.

5. Bandpassfilter für Schallwellen nach einem der Ansprüche 1 bis 4, **dadurch gekennzeichnet, dass** die phononische Kristallstruktur eindimensional ist.

6. Bandpassfilter für Schallwellen nach einem der Ansprüche 1 bis 4, **dadurch gekennzeichnet, dass** die phononische Kristallstruktur zweidimensional ist.

7. Bandpassfilter für Schallwellen nach Anspruch 1 oder 2, **dadurch gekennzeichnet, dass** die phononische Kristallstruktur dreidimensional ist.

8. Bandpassfilter für Schallwellen nach einem der Ansprüche 1 bis 7, **dadurch gekennzeichnet, dass** das piezoelektrische Material aus AIN ist.

9. Bandpassfilter für Schallwellen nach einem der Ansprüche 1 bis 7, **dadurch gekennzeichnet, dass** das piezoelektrische Material aus LiNbO₃ ist.

10. Bandpassfilter für Schallwellen nach einem der Ansprüche 1 bis 9, **dadurch gekennzeichnet, dass** die phononische Kristallstruktur Einschlüsse und/oder verteilte Spezies umfasst.

11. Bandpassfilter für Schallwellen nach einem der Ansprüche 9 und 10, **dadurch gekennzeichnet, dass** die Einschlüsse durch Implantieren von Wasserstoffatomen erhalten werden.

12. Bandpassfilter für Schallwellen nach einem der Ansprüche 1 bis 9, **dadurch gekennzeichnet, dass** die phononische Kristallstruktur Löcher umfasst.

13. Bandpassfilter für Schallwellen nach einem der Ansprüche 1 bis 12, **dadurch gekennzeichnet, dass** es ferner zweite phononische Kristallstrukturen (CP₂) an der Peripherie der Resonatoren umfasst, die Dämpfungskoeffizienten für Schallwellen, lateral genannt, aufweisen, die größer sind als die Dämpfungskoeffizienten der ersten phononischen Kristallstrukturen, die sich zwischen den beiden Resonatoren befinden.

14. Bandpassfilter für Schallwellen nach einem der Ansprüche 1 bis 13, **dadurch gekennzeichnet, dass** die Resonatoren eine obere Elektrode und eine untere Elektrode umfassen.

15. Bandpassfilter für Schallwellen nach einem der Ansprüche 1 bis 13, **dadurch gekennzeichnet, dass** die Resonatoren ein Elektrodenpaar umfassen, das an der Oberfläche des piezoelektrischen Materials positioniert ist.

16. Bandpassfilter für Schallwellen nach einem der Ansprüche 1 bis 15, **dadurch gekennzeichnet, dass** es ferner eine akustische Struktur umfasst, die es zulässt, das Filter akustisch zu isolieren, wobei diese Struktur ein Bragg-Spiegel und/oder ein Hohlraum und/oder eine dritte phononische Kristallstruktur ist.

## Claims

1. An acoustic wave bandpass filter comprising at least two bulk acoustic wave resonators, laterally acoustically coupled together, each resonator comprising a layer of piezoelectric material (P_{iezo}) and at least one first electrode (Eₛ₁, Eₛ₂, Eₛ) and/or one second electrode (Eᵢ₁, Eᵢ₂, Eₛ), said bulk waves propagating in a direction perpendicular to the plane of the layer of piezoelectric material, **characterised in that**:
- it further comprises at least one first phononic crystal structure (CP₁) having a periodic arrangement of a plurality of acoustically different materials generating stop bands corresponding to frequency ranges, for which no acoustic wave propagates between said resonators, and being disposed so as to be able to decrease the transmission coefficient of the lateral acoustic waves in a direction parallel to the plane of the piezoelectric layer;
- the first phononic crystal structure is formed in a matrix of dielectric material or with patterns made of dielectric material.

2. The acoustic wave bandpass filter as claimed in claim 1, **characterised in that** the phononic crystal structure is located in the layer of piezoelectric material.

3. The acoustic wave bandpass filter as claimed in claim 1, **characterised in that**, with the resonators being formed from a stack of layers, the phononic crystal structure comprises patterns on the surface of the stack and/or under said stack and/or in at least one layer of said stack.

4. The acoustic wave bandpass filter as claimed in claim 3, **characterised in that** the patterns of the phononic structure are made of SiO₂ or SiN or Mo or W or AIN.

5. The acoustic wave bandpass filter as claimed in any one of claims 1 to 4, **characterised in that** the phononic crystal structure is one-dimensional.

6. The acoustic wave bandpass filter as claimed in any one of claims 1 to 4, **characterised in that** the phononic crystal structure is two-dimensional.

7. The acoustic wave bandpass filter as claimed in claim 1 or 2, **characterised in that** the phononic crystal structure is three-dimensional.

8. The acoustic wave bandpass filter as claimed in any one of claims 1 to 7, **characterised in that** the piezoelectric material is made of AIN.

9. The acoustic wave bandpass filter as claimed in any one of claims 1 to 7, **characterised in that** the piezoelectric material is made of LiNbO₃.

10. The acoustic wave bandpass filter as claimed in any one of claims 1 to 9, **characterised in that** the phononic crystal structure comprises inclusions and/or diffused species.

11. The acoustic wave bandpass filter as claimed in claims 9 and 10, **characterised in that** the inclusions are obtained by implanting hydrogen atoms.

12. The acoustic wave bandpass filter as claimed in any one of claims 1 to 9, **characterised in that** the phononic crystal structure comprises holes.

13. The acoustic wave bandpass filter as claimed in any one of claims 1 to 12, **characterised in that** it further comprises second phononic crystal structures (CP₂) on the periphery of said resonators, which structures have attenuation coefficients for the acoustic waves, called lateral waves, that are greater than the attenuation coefficients of the first phononic crystal structures located between said two resonators.

14. The acoustic wave bandpass filter as claimed in any one of claims 1 to 13, **characterised in that** the resonators comprise an upper electrode and a lower electrode.

15. The acoustic wave bandpass filter as claimed in any one of claims 1 to 13, **characterised in that** the resonators comprise a pair of electrodes positioned on the surface of the piezoelectric material.

16. The acoustic wave bandpass filter as claimed in any one of claims 1 to 15, **characterised in that** it further comprises an acoustic structure for acoustically isolating the filter, said structure being a Bragg mirror and/or a cavity and/or a third phononic crystal structure.
